# DEMANDE DE BREVET EUROPEEN

(11) **EP 1 028 367 A1**
(43) Date de publication de la demande: **16.08.2000**
(21) Numéro de dépôt: 00400299.4
(22) Date de dépôt: 03.02.2000
(51) Int. Cl.: G06F 3/06, G06F 11/20

(54) **Dispositif et procédé d'amélioration des performances en écriture d'un périphérique de stockage de données pour ordinateur**

(30) Priorité: 11.02.1999 FR 9901649
(71) Demandeur: BULL S.A., 78430 Louveciennes (FR)
(72) Inventeur: Carteau, Daniel, 78180 Montigny le Bretonneux (FR)

(57) **Abrégé**

La solution a pour objet, dans un système informatique, l'écriture de données sur au moins un périphérique de stockage de données (PER) incluant au moins un moyen de stockage de données (STO) et au moins une mémoire volatile (MV1) servant de mémoire tampon incluant les données à écrire sur au moins ledit moyen de stockage STO, le système comprenant au moins un système hôte (SH) relié à au moins ledit périphérique de stockage (PER) par l'intermédiaire de liaisons pour échanger entre eux des informations incluant notamment des données à écrire sur au moins ledit périphérique de stockage (PER), le système hôte (SH) comprenant au moins une mémoire (MV2) pouvant contenir les données à écrire sur au moins ledit moyen de stockage, le procédé comprenant une demande d'écriture consistant à émettre une commande d'écriture sur une lesdites liaisons et est caractérisé en ce qu'il consiste à sauvegarder, par l'intermédiaire d'au moins un moyen de sauvegarde de données non-volatile (MEM), les données à écrire sur ledit au moins un moyen de stockage (STO) pendant au moins la durée d'écriture de ces données sur ledit au moins un moyen de stockage (STO) et en ce qu'il consiste, suite à cette sauvegarde, à transmettre au système hôte un message de terminaison d'écriture de données dans au moins ledit moyen de sauvegarde de données non-volatile (MEM).

## Description

### Domaine technique

La présente invention a pour objet un procédé d'écriture de données numériques sur un périphérique de stockage de données.

Un périphérique de stockage comprend des moyens de stockage qui peuvent être indifféremment une bande magnétique, un disque optique, un disque magnétique, un disque dur, un disque souple ou disquette, ou tout autre moyen de stockage de données de grande capacité. Ces différents moyens de stockage appartiennent à la famille des mémoires dites de masse étant donné la grande capacité de celles-ci par rapport aux mémoires à semi-conducteur de type volatile RAM (Random Access Memory) ou antémémoire, et de type non-volatile, par exemple une mémoire de la famille ROM (Read Only Memory) telle qu'une mémoire EEPROM (Electrically Eraseable Programmable Read Only Memory), une mémoire EPROM (Electrically Programmable Read Only Memory) Flash, etc. Les mémoires volatiles à semi-conducteur sont utilisées pour stocker temporairement des données. Dans l'exemple choisi, le périphérique de stockage comprend une antémémoire utilisée à la fois en lecture et en écriture. Une antémémoire est connue pour ses propriétés de temps d'accès très court et d'accélération du traitement des données. En écriture, cette antémémoire fait office de mémoire tampon plus connue sous le nom de 〈〈buffer〉〉 pour un homme du métier. En lecture, une antémémoire stocke des données auxquelles un accès est bientôt prévu.

Plus particulièrement, le système informatique peut comprendre un ou plusieurs périphériques de stockage. De même, un périphérique de stockage peut comprendre un ou plusieurs moyens de stockage.

De façon générale, le choix du moyen de stockage est fonction des informations à stocker sur celui-ci. Ce moyen de stockage sera, dans l'exemple choisi, un disque magnétique. Dans l'exemple choisi, le périphérique de stockage constitue un système assurant une haute intégrité des données.

Les données à écrire sont issues d'un système hôte. Ce système hôte comprend au moins un microprocesseur et des mémoires de type quelconques qui lui sont reliées.

Il en résulte un système informatique pour la mise en oeuvre du procédé.

### L'état de la technique

L'écriture de données sur un moyen de stockage tel que les disques magnétiques est précédée successivement d'une écriture de ces données dans une mémoire du système hôte et dans une mémoire volatile du périphérique de stockage. De préférence, la mémoire volatile du périphérique de stockage est une antémémoire.

De manière générale, un périphérique de stockage est caractérisé, outre sa haute protection de l'intégrité des données, à la fois par son temps d'accès à la donnée recherchée sur le moyen de stockage et par son temps d'écriture des données à stocker sur le moyen de stockage.

Lorsqu'on désire lire des données dans un périphérique de stockage,
■ le système hôte transmet au périphérique de stockage, à travers une interface de périphérique qui peut être quelconque associée au périphérique de stockage de données, notamment une commande de lecture incluant le numéro du premier bloc de données à lire ainsi que le nombre de blocs de données à lire.. Cette interface peut être de type SCSI (Small Computer System Interface), FC-AL (Fiber Channel-Arbitred Loop), P1394 (firewire, Bus série), ATA (Advanced Technology Attachment), etc.
■ une lecture des données est réalisée sur le moyen de stockage,
■ les données lues sont stockées dans l'antémémoire du périphérique de stockage,
■ le périphérique de stockage, géré par un microprocesseur, transmet au système hôte un message signalant que les données sont stockées dans l'antémémoire,
■ et, le système hôte transmet alors une commande autorisant l'envoi des données lues.

Lorsque l'on veut écrire des informations dans un périphérique de stockage,
■ les données à écrire sont stockées dans une mémoire du système hôte,
■ les données sont envoyées par le système hôte à travers une interface de périphérique qui peut être quelconque SCSI (Small Computer System Interface), FC-AL (Fiber Channel-Arbitred Loop), P1394 (firewire, Bus série), ATA (Advanced Technology Attachment), etc., associée au périphérique de stockage de données,
■ ces données sont ensuite stockées dans l'antémémoire du périphérique, cette antémémoire faisant office de mémoire dite tampon (buffer), connue de l'homme du métier,
■ et, le périphérique accède à un emplacement sur le moyen de stockage en fonction de l'adresse où les données doivent être stockées. Cet accès est électro-mécanique. Il nécessite, dans le cas de moyens de stockage de type 〈〈disques〉〉,
   a) un déplacement du bras supportant les têtes d'écriture/lecture (temps d'accès),
   b) la sélection de la tête désirée,
   c) ainsi qu'une attente du moment où l'emplacement visé passera sous les tètes (latence).

En définitive, le temps d'accès, par exemple pour un moyen de stockage performant de type disques magnétiques, peut s'évaluer en moyenne à 14-15 ms. Ce temps d'accès peut dépasser 25 ms suivant les cas.

Lorsque le bras est bien positionné, l'enregistrement des données peut donc débuter. Il prendra un certain temps qu'il faudra ajouter au précédent et qui sera dépendant du débit des données imposé, de la taille des données à écrire, de la "perte de tours" pouvant arriver dans certains cas et également sera allongé s'il est nécessaire de changer de piste ou de tête pour terminer l'enregistrement.

Dans le cas d'unités de disques moins performantes, ces temps seront rallongés. Dans le cas de disques optiques, ce sera bien pire et dans le cas de dérouleurs de bande magnétique, l'unité de temps utilisée sera proche de la seconde.

Il faut bien prendre en compte que l'opération d'écriture ne sera terminée que lorsque toutes les données faisant partie du même enregistrement seront écrites sur le moyen de stockage. Alors, le périphérique de stockage transmettra en direction du système hôte un message de terminaison correcte de fin d'écriture.

Le gros problème est que le système hôte devra garder dans sa mémoire les données en cours d'écriture jusqu'à leur écriture effective sur le moyen de stockage. Si un incident survenait, empêchant l'écriture partiellement ou en totalité des données, il sera absolument nécessaire de retrouver ces données et de les réécrire à l'emplacement prévu. Le fait, pour le système hôte, d'avoir des enregistrements à conserver dans sa mémoire pendant des temps très longs comparativement à sa vitesse de calcul, le ralentit et donc limite ses performances.

Une solution est d'utiliser une fonction fournissant un message de terminaison d'écriture sur l'antémémoire du périphérique de stockage. Cette fonction est autorisée dans le périphérique de stockage en positionnant un certain indicateur dans la commande d'écriture issue du système hôte. Le positionnement de l'indicateur à une certaine valeur, 0 ou 1, permet d'utiliser l'antémémoire du disque comme initiateur du message de terminaison d'écriture.

L'utilisation de cette fonction présente un deuxième problème. Lorsque l'on utilise cette fonction, le disque envoie en direction du système hôte un message de terminaison correcte de la requête d'écriture dès que les données sont stockées dans l'antémémoire du disque (les opérations d'accès étant cachées). Le problème est que si une panne du disque ou une panne d'alimentation du disque survient entre le moment où le disque a remonté son information de terminaison correcte à l'hôte et le moment où la totalité des informations est écrite physiquement sur le moyen de stockage, il y a perte de données. Ceci est inacceptable dans un domaine où l'intégrité des données est la pièce maîtresse et donc où la perte de données n'est pas envisageable.

Une autre solution au premier problème est d'incorporer un élément supplémentaire dans la chaîne, constitué par le système hôte et le périphérique de stockage, comme une carte contrôleur de disques. Le contrôleur de disques pouvant supporter les fonctions RAID (Redundant Array on an Inexpensive Disks) ou non. Dans ce cas, une antémémoire associée au contrôleur gardera les données en cours d'écriture en lieu et place de la mémoire associée au système hôte. Cette solution impose un coût en argent important en ce sens qu'il faudra payer la fonction contrôleur, payer l'antémémoire et surtout s'assurer que la fonction supporte une panne sans risque de perte d'information. La plupart du temps, on a recours à de la mémoire sauvegardée par batterie avec une durée limitée, ou à du stockage de données redondante tel que dans les systèmes RAID (Redundant Array of Independent Disks) connus de l'homme du métier. Ce type de stockage impose de la sauvegarde de données sur des zones de disques particulières (avec également une batterie), etc. Tout cela a un coût non négligeable sans compter que le fait de rajouter un maillon dans la chaîne ajoute quelques milli-secondes au temps de réponse.

Une autre solution est de mettre en place la solution d'écriture rapide sur disques de manière sécurisée telle qu'elle a été décrite dans la demande de brevet n°98 13987 de la demanderesse. Cette mise en oeuvre nécessite du matériel au niveau du périphérique de stockage et du logiciel au-dessus du driver.

### Sommaire de l'invention

Un premier but est d'augmenter les performances en écriture d'un système informatique tout en procurant au système une haute protection de l'intégrité des données.

Un deuxième but est de la possibilité d'écrire des données sur les moyens de stockage sans ralentir les performances du système hôte.

Un autre but visé est de réduire considérablement le coût en argent d'une telle mise en oeuvre.

A cet effet, l'invention a pour objet, dans un système informatique, un procédé d'écriture de données sur au moins un périphérique de stockage de données incluant au moins un moyen de stockage de données et au moins une mémoire volatile servant de mémoire tampon incluant les données à écrire sur au moins ledit moyen de stockage, le système comprenant au moins un système hôte relié à au moins ledit périphérique de stockage par l'intermédiaire de liaisons pour échanger entre eux des informations incluant notamment des données à écrire sur au moins ledit périphérique de stockage, le système hôte comprenant au moins une mémoire pouvant contenir les données à écrire sur au moins ledit moyen de stockage, le procédé comprenant une demande d'écriture consistant à émettre une commande d'écriture sur une lesdites liaisons et est caractérisé en ce qu'il consiste à sauvegarder, par l'intermédiaire d'au moins un moyen de sauvegarde de données non-volatile, les données à écrire sur ledit au moins un moyen de stockage pendant au moins la durée d'écriture de ces données sur ledit au moins un moyen de stockage et en ce qu'il consiste, suite à cette sauvegarde, à transmettre au système hôte un message de terminaison d'écriture de données dans au moins ledit moyen de sauvegarde de données non-volatile.

Il en résulte un système informatique comprenant au moins un périphérique de stockage de données incluant au moins un moyen de stockage de données et au moins mémoire volatile servant de mémoire tampon incluant les données à écrire sur au moins ledit un moyen de stockage, le système comprenant au moins un système hôte relié audit au moins une périphérique de stockage par l'intermédiaire de liaisons pour échanger entre eux des informations incluant notamment des données à écrire sur au moins ledit périphérique de stockage, le système hôte comprenant au moins une mémoire pouvant contenir les données à écrire sur au moins ledit moyen de stockage, une demande d'écriture consistant à émettre une commande d'écriture sur une desdites liaisons, caractérisé en que la mémoire volatile est substituée à au moins une mémoire non-volatile ou est reliée à au moins une mémoire non-volatile pour constituer un moyen de sauvegarde non-volatile.

Les solutions apportées seront mieux comprises à la lecture de la description qui suit, donnée à titre d'exemple et faite en référence aux dessins annexés.

### Description d'un exemple de réalisation

### Dans les dessins:

Pour simplifier la description, dans les dessins les mêmes éléments portent les mêmes références.
- La figure 1 est une vue synoptique de l'architecture d'un système informatique incluant un système hôte et un périphérique de stockage sur le quel peut s'appliquer la solution, et

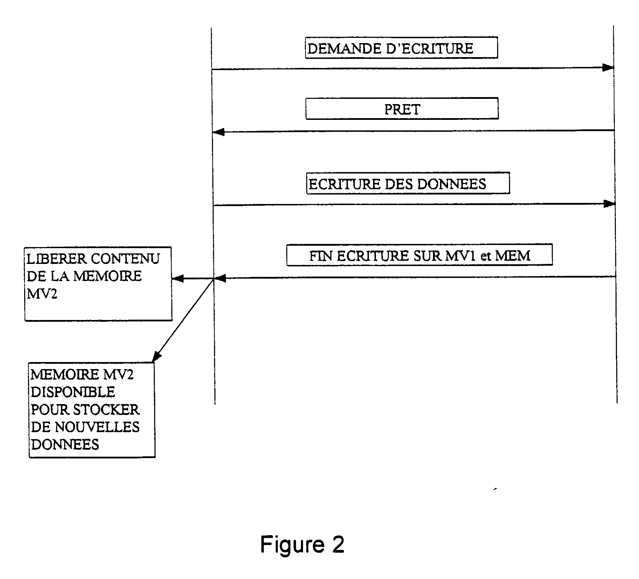

- la figure 2 est une vue schématique des différents échanges d'information entre le système hôte et le périphérique de stockage conformément à la solution.

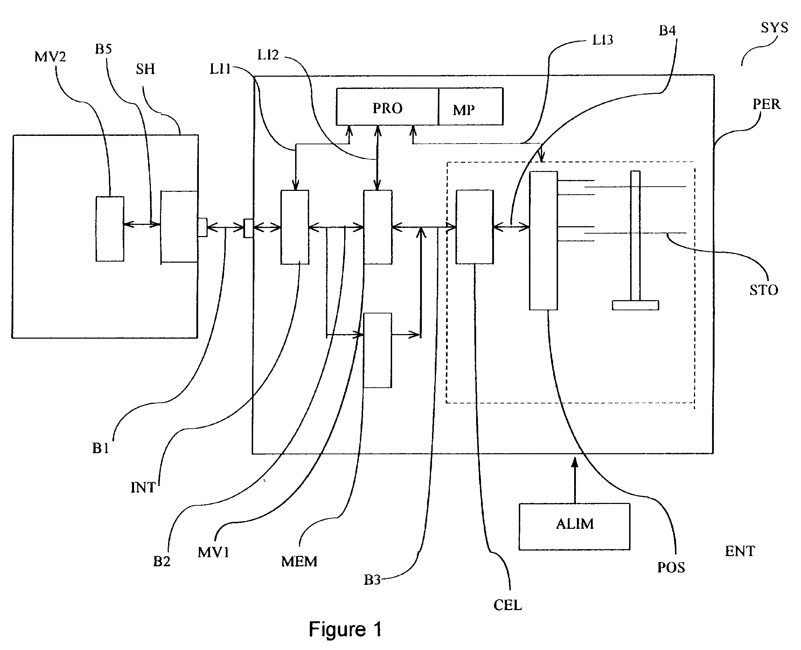

Sur la figure 1, on a représenté un système informatique SYS comprenant un système hôte SH et un périphérique de stockage PER. Dans l'exemple illustré, le système hôte SH et un périphérique de stockage PER sont reliés entre eux, par exemple par l'intermédiaire d'un bus de type SCSI. Le système informatique peut comprendre plusieurs périphériques de stockage.

Dans l'exemple illustré, le périphérique de stockage PER comprend bien sûr une interface de type SCSI (Small Computer System Interface). De manière générale, la nature de l'interface est fonction de la nature du bus B1 utilisé. On peut trouver différents types d'interfaces telles que une interface SCSI (Small Computer System Interface), FC-AL (Fiber Channel-Arbitred Loop), P1394 (firewire, Bus série), ATA (Advanced Technology Attachment), etc. Il est connu que l'interface permet des liaisons standardisées à grande vitesse entre un système hôte et les différents périphériques auxquels il est connecté. Ce périphérique PER comprend une mémoire volatile MV1, de préférence une mémoire communément appelée antémémoire (appelée aussi mémoire-cache), connue de l'homme du métier. Dans la suite de la description, on utilisera le terme antémémoire pour désigner ce type de mémoire. De préférence, cette mémoire est utilisée à la fois en lecture et en écriture; une zone mémoire est donc dédiée à l'écriture de données sur ledit moyen de stockage et une zone mémoire est dédiée à la lecture de données. Cette antémémoire MV1 est une mémoire dont le temps d'accès est très court par rapport aux autres mémoires existantes. Cette antémémoire stocke temporairement des données à écrire sur un moyen de stockage.

Le périphérique comprend aussi un lecteur LEC incluant notamment
■ un moteur d'entraînement ENT du ou des disques,
■ les têtes de lecture/écriture,
■ un système de positionnement POS des têtes,
■ au moins un boîtier CEL comprenant les circuits électroniques assurant l'écriture des informations sur le disque, leur lecture et le contrôle des moteurs, et
■ un ou plusieurs moyens de stockage STO de type disque magnétiques.

Tous les éléments du périphérique de stockage PER sont alimentés par l'intermédiaire d'au moins une source d'alimentation ALIM.

Tous ces éléments sont sous le contrôle d'un microprocesseur PRO relié à au moins un microprogramme MP nécessaire pour exécuter toutes les instructions du microprocesseur. Ce microprocesseur est relié par des liaisons respectives LI1-LI3 à l'interface INT, à la mémoire MV1 et aux divers composants du lecteur LEC. Pour simplifier la description, les liaisons reliant le microprocesseur aux différents composants du lecteur LEC sont représentées sur la figure 1 par l'intermédiaire d'une seule liaison LI3.

Dans ce périphérique de stockage PER, l'interface INT reçoit en entrée le bus de type SCSI qui comprend plusieurs lignes. La description des différentes lignes est donnée dans la suite de la description. Un bus B2 de données relie la sortie de l'interface à l'entrée de l'antémémoire MV1. Un autre bus B3 relie la sortie de l'antémémoire MV1 à l'entrée du lecteur constitué par l'ensemble de boîtiers CEL. Dans le lecteur LEC un bus B4 relie la sortie de l'ensemble de boîtiers CEL au système de positionnement POS.

Le système hôte SH comprend également une mémoire quelconque MV2 dans laquelle on stocke notamment des données à écrire sur le périphérique PER. Pour des raisons de simplification de la description, on n'a pas représenté les autres éléments constitutifs du système hôte. Cette mémoire MV2 est également contrôlée par l'intermédiaire d'un microprocesseur associé à au moins un microprogramme, non représentés sur la figure. Le système hôte SH comprend un bus B5, par exemple du type PCI (Peripheral Component Interconnect). Un adaptateur de bus assure le raccordement du bus PCI au bus B1 de type SCSI.

Rappelons qu'un bus SCSI comprend plusieurs liaisons, notamment
■ un bus de données (ce bus peut comprendre huit lignes plus un bit de parité),
■ une ligne informe que le bus de données est occupé (par exemple, cette ligne est portée à 0 lorsque le bus est utilisé),
■ une ligne indique le numéro du périphérique de stockage sélectionné,
■ une ligne indique si une donnée ou une commande se trouve sur le bus de données,
■ une ligne indique le sens dans lequel les données circulent,
■ une ligne indique la présence d'un message sur le bus de données, par exemple la fin de la transmission est indiquée par un message approprié,
■ une ligne indique une demande de transfert de données,
■ une ligne indique une condition par exemple que le périphériques raccordé au bus B1 indiquent qu'il est prêt à recevoir ou à transmettre des messages,
■ une ligne fournit une tension d'alimentation pour les résistances en bout de chaîne, résistances propres au bus de type SCSI,
■ et une dernière ligne de réinitialisation utilisée à la mise sous tension ou lorsqu'un périphérique ne répond pas.

De façon concrète, lorsque l'on veut écrire des données sur un disque,
■ les données à écrire sur le périphérique de stockage sont stockées dans la mémoire MV2 du système hôte SH.
■ Les données sont envoyées par le système hôte SH à travers l'interface INT associée au périphérique de stockage de données PER.
■ Ces données sont ensuite stockées dans le périphérique lui-même dans la mémoire MV1 de préférence de type antémémoire, ou de type mémoire tampon plus connu sous le nom de 〈〈buffer〉〉 pour l'homme du métier.
■ et l'écriture effective des données sur le moyen de stockage STO.

Le gros problème est que le système hôte SH devra garder dans sa mémoire MV2 les données en cours d'écriture jusqu'à leur écriture effective sur le moyen de stockage STO. Comme évoqué dans l'introduction, si un incident survenait, empêchant l'écriture partiellement ou en totalité des données, il sera absolument nécessaire de les réécrire à l'emplacement prévu si le défaut était passager. Le fait d'avoir pour le système hôte SH, des enregistrements à conserver dans sa mémoire MV2 pendant des temps très longs comparativement à sa vitesse de calcul, le ralentit et donc limite ses performances.

Une solution à ce problème consiste, par l'intermédiaire d'au moins un moyen de sauvegarde de données non-volatile MEM, à sauvegarder les données à écrire pendant au moins la durée d'écriture de ces données sur ledit au moins un moyen de stockage STO, et en ce qu'il consiste à transmettre, au système hôte SH, un message de terminaison d'écriture de données. La mémoire MV2 du système hôte SH devient disponible pour le stockage de nouvelles données dès la réception du message de terminaison d'écriture des données sur ledit au moins un moyen de sauvegarde de données non-volatile MEM.

Dans l'exemple illustré, la solution consiste donc à rendre la mémoire MV1 non-volatile. Dans notre exemple, la mémoire volatile MV1 est utilisée en écriture et en lecture. Comme évoqué précédemment, il existe des zones mémoire dédiées à l'écriture et à la lecture. Dans ce dernier cas, la solution consiste à rendre au moins la zone mémoire dédiée à l'écriture non-volatile. Plus précisément, il consiste à rendre non-volatile la zone mémoire qui stocke les données à écrire sur le moyen de stockage. Ce peut être obtenu de diverses manières en utilisant, à la place de la mémoire MV1, au moins une mémoire non-volatile ou en utilisant des mémoires non volatiles en association avec la mémoire vive MV1.

Dans l'exemple de mise en oeuvre, la solution consiste à associer l'antémémoire MV1 à au moins une mémoire non-volatile MEM. Dans un exemple, les données sont sauvegardées dans au moins une mémoire non-volatile de type EEPROM pendant au moins la durée d'écriture de ces données sur le moyen de stockage. Plus précisément, dans l'exemple illustré, la mémoire volatile MV1 est reliée en parallèle à une mémoire non-volatile EEPROM. Il consiste ensuite à transmettre, au système hôte SH, un message de terminaison d'écriture de données dans ladite mémoire non-volatile EEPROM. Naturellement, la mémoire non-volatile ne se limite pas à une mémoire de type EEPROM mais à tout autre dispositif non-volatile. Rappelons pour information qu'une mémoire non-volatile se définit comme toute mémoire capable de conserver des données en cas de coupure de l'alimentation.

Selon une variante, l'association entre une mémoire volatile et une mémoire non-volatile constitue, par exemple, une mémoire de type NOVRAM (Non-volatile Random Access Memory) connue de l'homme du métier. Ce type de mémoire incorpore dans un même boitier des cellules RAM (Random Access Memory) et des cellules EEPROM. De préférence, cette mémoire non-volatile recoit en entrée les mêmes informations que reçoit la mémoire volatile MV1. Selon une variante, on sauvegarde systématiquement les données dans l'antémémoire MV1 et dans la mémoire non-volatile EEPROM. Selon une autre variante, les données sont stockées dans la mémoire non-volatile EEPROM uniquement lors de la détection de la panne. Dans ce dernier cas de figure, le temps de réaction de la sauvegarde doit être très court.

Dans un autre exemple de mise en oeuvre, la mémoire MV1 est reliée à un (ou plusieurs) superviseur de tension qui assure une commutation automatique de la mémoire MV1 sur une batterie de sauvegarde en cas de coupure de la tension secteur. Ainsi, la mémoire volatile MV1 est protégée contre l'écriture pendant la phase de commutation de tension et les données sont donc conservées. Dans cet exemple, la batterie de sauvegarde ou une pile doit être capable de fournir de l'énergie pendant un temps suffisamment long correspondant à la durée de la panne et de la réparation.

La source d'énergie permettant la sauvegarde des données dans la mémoire non-volatile peut être, dans un autre exemple, la récupération de l'énergie de rotation des disques. On élimine ainsi le besoin d'une batterie ou d'une pile.

Dès la réception du message de terminaison de l'écriture des données sur le moyen de sauvegarde de données non-volatile MEM, la zone mémoire de la mémoire MV2 du système hôte SH incluant les données à écrire sur le moyen de stockage STO peut donc être libérée en toute sécurité. On peut donc écrire de nouvelles données dans la zone libérée de la mémoire MV2 du système hôte SH avant même que les données ne soient écrites sur le moyen de stockage STO.

Dans l'exemple de mise en oeuvre, la solution comprend plusieurs étapes, notamment:

Lorsque l'on veut écrire des informations dans un périphérique de stockage,
■ les données à écrire sont stockées dans la mémoire MV2 du système hôte SH,
■ le système hôte SH transmets un message de demande d'écriture de données au périphérique de stockage PER par l'intermédiaire du bus B1.
■ le périphérique PER informe le système hôte SH qu'il est prêt à recevoir des données.
■ les données sont envoyées par le système hôte à travers l'interface de périphérique INT associée au périphérique de stockage de données PER.
■ Ces données sont ensuite stockées dans une zone mémoire de l'antémémoire MV1 du périphérique
■ Dans l'exemple illustré, les données sont stockées à la fois dans la mémoire volatile MV1 et la mémoire non-volatile MEM.
■ Une fois les données stockées sur la mémoire non-volatile MEM, un message de terminaison d'écriture des données est émis en direction du système hôte pour libérer le contenu de la zone mémoire de la mémoire MV2 du système hôte SH incluant les données écrites dans la mémoire non-volatile MEM. A ce stade, la mémoire MV2 du système hôte SH est disponible pour stocker de nouvelles données à écrire sur le périphérique de stockage PER. Il est donc possible d'écrire en parallèle de nouvelles données dans la mémoire MV2 du système hôte SH et les données sur les moyens de stockage STO.
■ Par la suite, le périphérique de stockage PER poursuit le stockage effectif des données. Le périphérique accède à un emplacement sur le moyen de stockage STO en fonction de l'adresse où les données doivent être stockées. Cet accès est électro-mécanique. Il nécessite, dans le cas de moyens de stockage de type 〈〈disques〉〉,
   a) un déplacement du bras supportant les tètes d'écriture/lecture (temps d'accès),
   b) la sélection de la tête désirée, etc.

En cas de panne du périphérique de stockage après la transmission du message de terminaison d'écriture par le périphérique de stockage PER, les données sont conservées en sécurité dans la mémoire non-volatile MEM. Cette sécurité donne le temps à un opérateur de remettre en marche le périphérique de stockage PER. Une panne du périphérique inclut par exemple une panne de l'alimentation ALIM qui peut être provoquée par une panne d'alimentation continue du disque, une panne de secteur ou une mauvaise manipulation par un opérateur suite à une extraction d'un disque.

Lorsque la panne est réparée et que les tests de mise sous tension révèlent une alimentation normale, le périphérique est de nouveau en état de marche et les données stockées dans la mémoire non-volatile MEM sont transmises pour l'écriture sur les moyens de stockage. Ces données sont écrites sur le moyen de stockage STO en totalité.

De façon générale, la solution a pour objet, dans un système informatique SYS, un procédé d'écriture de données sur au moins un périphérique de stockage de données PER incluant au moins un moyen de stockage de données STO et au moins une mémoire volatile MV1 servant de mémoire tampon incluant les données à écrire sur au moins ledit moyen de stockage STO, le système comprenant au moins un système hôte SH relié à au moins ledit périphérique de stockage PER par l'intermédiaire de liaisons pour échanger entre eux des informations incluant notamment des données à écrire sur au moins ledit périphérique de stockage PER, le système hôte SH comprenant au moins une mémoire MV2 pouvant contenir les données à écrire sur au moins ledit moyen de stockage, le procédé comprenant une demande d'écriture consistant à émettre une commande d'écriture sur une lesdites liaisons et est caractérisé en ce qu'il consiste à sauvegarder, par l'intermédiaire d'au moins un moyen de sauvegarde de données non-volatile MEM, les données à écrire sur ledit au moins un moyen de stockage STO pendant au moins la durée d'écriture de ces données sur ledit au moins un moyen de stockage STO et en ce qu'il consiste, suite à cette sauvegarde, à transmettre au système hôte un message de terminaison d'écriture de données dans au moins ledit moyen de sauvegarde de données non-volatile MEM.

On a vu que la solution consiste, à la réception du message de terminaison d'écriture des données sur au moins ledit moyen de sauvegarde de données non-volatile MEM, à libérer la zone mémoire de la mémoire MV2 du système hôte incluant les données écrites sur au moins ledit moyen de sauvegarde de données MEM. La solution donne donc la possibilité, après avoir libéré la zone mémoire de la mémoire MV2 du système hôte SH, d'effectuer une écriture de nouvelles données dans la mémoire MV2 du système hôte avant même la terminaison de l'écriture effective des données sur au moins ledit moyen de stockage STO.

On a vu aussi que, une fois les données écrites correctement sur au moins ledit moyen de stockage, à libérer la zone mémoire dudit au moins un moyen de sauvegarde non-volatile MEM incluant les données écrites.

Dans un exemple, La sauvegarde des données consiste, par l'intermédiaire dudit au moins un moyen de sauvegarde MEM, à transformer la mémoire volatile MV1 en une mémoire non volatile.

Cette sauvegarde se matérialise de différentes façons. Cette sauvegarde sur au moins ledit moyen de stockage MEM, peut consister à stocker les données dans au moins une mémoire non-volatile de type EEPROM. Cette sauvegarde sur au moins ledit moyen de stockage MEM, peut aussi consister à stocker les données à écrire sur au moins ledit moyen de stockage dans la mémoire volatile MV1 équipée d'un superviseur de tension pour assurer une commutation automatique de cette mémoire volatile MV1 sur une batterie de sauvegarde. Cette sauvegarde sur au moins ledit moyen de stockage MEM, peut aussi consister à stocker les données à écrire sur au moins ledit moyen de stockage dans la mémoire volatile MV1 du périphérique PER reliée en parallèle à au moins une mémoire non-volatile.

Il en résulte un système informatique SYS comprenant au moins un périphérique de stockage de données PER incluant au moins un moyen de stockage de données STO et au moins mémoire volatile MV1 servant de mémoire tampon incluant les données à écrire sur ledit au moins un moyen de stockage STO, le système comprenant au moins un système hôte SH relié audit au moins une périphérique de stockage PER par l'intermédiaire de liaisons pour échanger entre eux des informations incluant notamment des données à écrire sur ledit au moins un périphérique de stockage PER, le système hôte SH comprenant au moins une mémoire MV2 pouvant contenir les données à écrire sur ledit au moins un moyen de stockage, une demande d'écriture consistant à émettre une commande d'écriture sur une desdites liaisons, caractérisé en que la mémoire volatile MV1 est substituée à au moins une mémoire non-volatile ou est reliée à au moins une mémoire non-volatile pour constituer un moyen de sauvegarde non-volatile MEM. Dans l'exemple illustré, une demande d'écriture comprend un bit d'information propre à valider une fonction logicielle de terminaison d'écriture dans le moyen de sauvegarde des données MEM.

Il est clair que cette solution offre de nombreux avantages. La solution permet d'augmenter considérablement les performances en écriture d'un périphérique de stockage. Selon la solution, l'antémémoire MV1 du périphérique de stockage PER est transformée en mémoire non-volatile selon l'une des variantes évoquées précédemment. Les données risquant d'être perdues sont automatiquement conservées dans cette mémoire non-volatile et écrites sur le moyen de stockage après réparation. Le problème de l'intégrité des données est résolu. La zone mémoire de la mémoire MV2 du système hôte incluant les données à écrire est réutilisable dés la réception du message de terminaison de l'écriture des données sur le moyen de sauvegarde MEM. On peut donc écrire de nouvelles données dans la mémoire MV2 du système hôte SH avant même que les données ne soient écrites sur le moyen de stockage STO. Avec une telle structure, le temps de réponse à une écriture de données est de l'ordre de la milli-seconde. Le système hôte libère donc beaucoup plus rapidement sa mémoire MV2. Les performances du système hôte SH s'en trouvent de ce fait très nettement améliorées. Un autre avantage est le coût extrêmement faible d'une telle solution. Selon, la solution choisie, le coût correspond à la mémoire non-volatile.

## Revendications

1. Procédé, dans un système informatique (SYS), d'écriture de données sur au moins un périphérique de stockage de données (PER) incluant au moins un moyen de stockage de données (STO) et au moins une mémoire volatile (MV1) servant de mémoire tampon incluant les données à écrire sur au moins ledit moyen de stockage STO, le système comprenant au moins un système hôte (SH) relié à au moins ledit périphérique de stockage (PER) par l'intermédiaire de liaisons pour échanger entre eux des informations incluant notamment des données à écrire sur au moins ledit périphérique de stockage (PER), le système hôte (SH) comprenant au moins une mémoire (MV2) pouvant contenir les données à écrire sur au moins ledit moyen de stockage, le procédé comprenant une demande d'écriture consistant à émettre une commande d'écriture sur une lesdites liaisons et est caractérisé en ce qu'il consiste à sauvegarder, par l'intermédiaire d'au moins un moyen de sauvegarde de données non-volatile (MEM), les données à écrire sur ledit au moins un moyen de stockage (STO) pendant au moins la durée d'écriture de ces données sur ledit au moins un moyen de stockage (STO) et en ce qu'il consiste, suite à cette sauvegarde, à transmettre au système hôte un message de terminaison d'écriture de données dans au moins ledit moyen de sauvegarde de données non-volatile (MEM).

2. Procédé selon la revendication 1, caractérisé en ce qu'il consiste, à la réception du message de terminaison d'écriture des données sur au moins ledit moyen de sauvegarde de données non-volatile (MEM), à libérer la zone mémoire de la mémoire MV2 du système hôte incluant les données écrites sur au moins ledit moyen de sauvegarde de données (MEM).

3. Procédé selon la revendication 1 ou 2, caractérisé en ce qu'il consiste, après avoir libéré la zone mémoire de la mémoire (MV2) du système hôte (SH), à effectuer une écriture de nouvelles données dans la mémoire (MV2) du système hôte avant même la terminaison de l'écriture effective des données sur au moins ledit moyen de stockage (STO).

4. Procédé selon l'une des revendications 1 à 3, caractérisé en ce qu'il consiste, une fois les données écrites correctement sur au moins ledit moyen de stockage, à libérer la zone mémoire dudit au moins un moyen de sauvegarde non-volatile (MEM) incluant les données écrites.

5. Procédé selon l'une des revendications 1 à 4, caractérisé en ce qu'il consiste, par l'intermédiaire dudit au moins un moyen de sauvegarde (MEM), à transformer la mémoire volatile (MV1) en une mémoire non volatile.

6. Procédé selon la revendication 5, caractérisé en ce que la sauvegarde sur au moins ledit moyen de stockage (MEM), consiste à stocker les données dans au moins une mémoire non-volatile de type EEPROM (Electrically Eraseable Programmable Read Only Memory).

7. Procédé selon la revendication 5, caractérisé en ce que la sauvegarde sur au moins ledit moyen de stockage (MEM), consiste à stocker les données à écrire sur au moins ledit moyen de stockage dans la mémoire volatile (MV1) équipée d'un superviseur de tension pour assurer une commutation automatique de cette mémoire volatile (MV1) sur une batterie de sauvegarde.

8. Procédé selon la revendication 5, caractérisé en ce que la sauvegarde sur au moins ledit moyen de stockage (MEM), consiste à stocker les données à écrire sur au moins ledit moyen de stockage dans la mémoire volatile (MV1) du périphérique (PER) reliée en parallèle à au moins une mémoire non-volatile.

9. Système informatique (SYS) comprenant au moins un périphérique de stockage de données (PER) incluant au moins un moyen de stockage de données (STO) et au moins mémoire volatile (MV1) servant de mémoire tampon incluant les données à écrire sur au moins ledit un moyen de stockage STO, le système comprenant au moins un système hôte (SH) relié audit au moins une périphérique de stockage (PER) par l'intermédiaire de liaisons pour échanger entre eux des informations incluant notamment des données à écrire sur au moins ledit périphérique de stockage (PER), le système hôte (SH) comprenant au moins une mémoire (MV2) pouvant contenir les données à écrire sur au moins ledit moyen de stockage, une demande d'écriture consistant à émettre une commande d'écriture sur une desdites liaisons, caractérisé en que, pour la mise en oeuvre du procédé défini par l'une des revendications 1 à 8, la mémoire volatile (MV1) est substituée à au moins une mémoire non-volatile ou est reliée à au moins une mémoire non-volatile pour constituer un moyen de sauvegarde non-volatile (MEM).

10. Système selon la revendication 9, caractérisé en ce qu'une demande d'écriture comprend un bit d'information propre à valider une fonction logicielle de terminaison d'écriture dans le moyen de sauvegarde des données (MEM).
